# DEMANDE DE BREVET EUROPEEN

(11) **EP 4 199 286 A1**
(43) Date de publication de la demande: **21.06.2023**
(21) Numéro de dépôt: 22213485.0
(22) Date de dépôt: 14.12.2022
(51) Int. Cl.: H02H 3/16, H02H 7/26, H02J 3/36

(54) **PROCÉDÉS ET SYSTÈMES POUR GÉRER UN DÉFAUT D'ISOLEMENT DANS UNE INSTALLATION ÉLECTRIQUE**

(30) Priorité: 15.12.2021 FR 2113587
(71) Demandeur: SCHNEIDER ELECTRIC INDUSTRIES SAS, 92500 Rueil-Malmaison (FR)
(72) Inventeur: STEPANEK, Jiri, 38400 SAINT MARTIN D'HERES (FR); STOKMAN, Henricus David, 1431XP AALSMEER, Pays-Bas (NL)
(74) Mandataire: Lavoix

(57) **Abrégé**

Ce système pour gérer un défaut d'isolement dans une installation électrique (2) comporte un dispositif de supervision (26), des dispositifs de mesure (28) configurés pour mesurer une grandeur électrique dans l'installation, et des interrupteurs (41, 42, 43, 44, 30, 32, 34) pilotés par le dispositif de supervision, le dispositif de supervision étant configuré pour :
• détecter un premier défaut d'isolement dans l'installation ;
• détecter un deuxième défaut d'isolement dans l'installation ;
• commander automatiquement l'ouverture d'un des interrupteurs (41, 42, 43, 44, 30, 32, 34) associés à des bornes de sorties (L+, L-, M) afin de supprimer l'un des défauts électriques détectés, le choix de l'interrupteur à ouvrir étant réalisé en fonction de la localisation des défauts d'isolement détectés et de lois de commande prédéfinies permettant de ne déconnecter qu'une partie des charges électriques.

## Description

La présente invention concerne des procédés et des dispositifs pour gérer un défaut d'isolement dans une installation électrique, notamment dans une installation de distribution d'électricité.

L'invention est tout particulièrement applicable aux installations électriques dans lesquelles les phases électriques et la ligne de neutre ne sont pas connectées à la terre (par exemple les installations suivant un schéma de liaison à la terre de type IT).

Dans de telles installations, il est courant d'utiliser un système de détection dont le but est de détecter et de localiser des défauts d'isolement résultant d'une mise en contact inopinée entre une des phases (ou le neutre) et la terre.

En pratique, lorsqu'un tel défaut d'isolement survient de façon isolée, ce défaut ne pose pas toujours de danger immédiat pour l'installation, de sorte qu'il n'est pas forcément nécessaire d'interrompre le fonctionnement de toute l'installation tant qu'aucun autre défaut d'isolement n'apparaît. L'installation peut continuer à fonctionner en attendant que le défaut soit localisé et qu'un opérateur puisse être dépêché sur place pour supprimer le problème à l'origine du défaut. En revanche, si un deuxième défaut d'isolement survient alors que le premier défaut d'isolement est toujours présent, alors il est nécessaire d'agir pour supprimer immédiatement au moins l'un des défauts d'isolement.

Dans les installations actuelles, les charges électriques de l'installation sont protégées par des dispositifs de protection, tels que des disjoncteurs ou fusibles, qui déconnectent toutes les charges électriques lorsqu'un deuxième défaut est détecté.

Cela présente l'inconvénient que l'alimentation de toutes les charges électriques est alors interrompue, même pour les charges électriques qui n'étaient pas affectées par le défaut électrique. Cela force l'arrêt de toute l'installation et empêche d'assurer une continuité de service, ce qui peut être préjudiciable dans certaines applications, notamment dans des installations tertiaires ou industrielles.

C'est à ces inconvénients qu'entend plus particulièrement remédier l'invention en proposant des procédés et des dispositifs pour gérer un défaut d'isolement dans une installation électrique de façon à préserver la sécurité de l'installation tout en assurant une qualité de service satisfaisante.

A cet effet, un aspect de l'invention concerne un système pour gérer des défauts d'isolement dans une installation électrique, l'installation électrique comportant une alimentation électrique, un dispositif de conversion de puissance, et des lignes d'alimentation électriques étant configurées pour alimenter électriquement des charges électriques, chaque ligne d'alimentation électrique étant raccordée à une borne de sortie du dispositif de conversion de puissance, choisie parmi une première borne de sortie, une deuxième borne de sortie et une borne de sortie intermédiaire, le système comportant un dispositif de supervision, des dispositifs de mesure configurés pour mesurer une grandeur électrique dans l'installation, et des interrupteurs pilotés par le dispositif de supervision, le dispositif de supervision étant configuré pour :
- détecter un premier défaut d'isolement dans l'installation ;
- détecter un deuxième défaut d'isolement dans l'installation ;
- commander automatiquement l'ouverture d'un des interrupteurs associés aux bornes de sorties afin de supprimer l'un des défauts électriques détectés, le choix de l'interrupteur à ouvrir étant réalisé en fonction de la localisation des défauts d'isolement détectés et de lois de commande prédéfinies permettant de ne déconnecter qu'une partie des charges électriques.

Selon des aspects avantageux mais non obligatoires, un tel procédé de détection peut incorporer une ou plusieurs des caractéristiques suivantes, prises isolément ou suivant toute combinaison techniquement admissible :
- le dispositif de supervision est configuré pour, si le premier défaut d'isolement est détecté sur la borne de sortie intermédiaire et si le deuxième défaut d'isolement est détecté sur la première borne de sortie ou sur la deuxième borne de sortie, déconnecter l'interrupteur correspondant à cette autre borne de sortie pour faire disparaître le deuxième défaut d'isolement, sans ouvrir l'interrupteur associé à la borne de sortie intermédiaire ;
- le dispositif de supervision est configuré pour, si le premier défaut d'isolement est détecté sur la première borne de sortie ou sur la deuxième borne de sortie, ouvrir l'interrupteur correspondant à la borne de sortie pour laquelle le premier défaut a été détecté, au moyen de l'interrupteur, et ce quel que soit l'endroit où le deuxième défaut d'isolement est détecté ;
- le dispositif de supervision est configuré pour, si le premier défaut et le deuxième défaut d'isolement se produisent sur la première borne de sortie et la deuxième borne de sortie et qu'aucun défaut d'isolement n'affecte la borne de sortie intermédiaire, déconnecter la borne de sortie qui parmi la première borne de sortie et la deuxième borne de sortie présente la priorité la moins élevée, pour éliminer le défaut d'isolement associé à cette borne de sortie de sortie, de manière à pouvoir maintenir l'autre borne de sortie connectée, sans déconnecter la borne de sortie intermédiaire ;
- le dispositif de supervision est configuré pour détecter automatiquement le premier défaut d'isolement et le deuxième défaut d'isolement dans l'installation à partir des mesures fournies par les dispositifs de mesure ;
- le dispositif de supervision est configuré pour détecter automatiquement le premier défaut d'isolement et le deuxième défaut d'isolement dans l'installation à partir des mesures fournies par un contrôleur permanent d'isolement connecté à l'installation ;
- le dispositif de supervision est configuré pour empêcher la déconnexion de la borne de sortie intermédiaire.

Selon un autre aspect, l'invention concerne une installation de distribution électrique comportant une alimentation électrique, un dispositif de conversion de puissance, et des lignes d'alimentation électriques étant configurées pour alimenter électriquement des charges électriques, chaque ligne d'alimentation électrique étant raccordée à une borne de sortie du dispositif de conversion de puissance, choisie parmi une première borne de sortie, une deuxième borne de sortie et une borne de sortie intermédiaire, le système comportant un dispositif de supervision telle que décrit ci-dessus.

Selon un autre aspect, les charges présentant une priorité plus élevée sont connectées entre la borne de sortie intermédiaire et l'une ou l'autre des première et deuxième bornes de sortie.

Selon un autre aspect, l'invention concerne un procédé pour gérer des défauts d'isolement dans une installation électrique, l'installation électrique comportant une alimentation électrique, un dispositif de conversion de puissance, et des lignes d'alimentation électriques étant configurées pour alimenter électriquement des charges électriques, chaque ligne d'alimentation électrique étant raccordée à une borne de sortie du dispositif de conversion de puissance, choisie parmi une première borne de sortie, une deuxième borne de sortie et une borne de sortie intermédiaire, le système comportant un dispositif de supervision, des dispositifs de mesure configurés pour mesurer une grandeur électrique dans l'installation, et des interrupteurs pilotés par le dispositif de supervision, le procédé comportant des étapes consistant à :
- détecter un premier défaut d'isolement dans l'installation ;
- détecter un deuxième défaut d'isolement dans l'installation ;
- commander automatiquement l'ouverture d'un des interrupteurs associés aux bornes de sorties afin de supprimer l'un des défauts électriques détectés, le choix de l'interrupteur à ouvrir étant réalisé en fonction de la localisation des défauts d'isolement détectés et de lois de commande prédéfinies permettant de ne déconnecter qu'une partie des charges électriques.

L'invention sera mieux comprise et d'autres avantages de celle-ci apparaîtront plus clairement à la lumière de la description qui va suivre d'un mode de réalisation d'un procédé pour détecter un défaut d'isolement dans une installation électrique, donnée uniquement à titre d'exemple et faite en référence aux dessins annexés, dans lesquels :
[Fig 1] la figure 1 est un schéma simplifié d'une installation électrique comportant un système pour détecter un défaut d'isolement selon un premier mode de réalisation de l'invention ;
[Fig 2] la figure 2 est un schéma simplifié d'une installation électrique comportant un système pour détecter un défaut d'isolement selon un deuxième mode de réalisation de l'invention ;
[Fig 3] la figure 3 est un schéma simplifié d'une installation électrique comportant un système pour détecter un défaut d'isolement selon un troisième mode de réalisation de l'invention ;
[Fig 4] la figure 4 est un diagramme d'un procédé pour détecter un défaut d'isolement dans l'installation électrique de la figure 1 selon un mode de réalisation de l'invention.

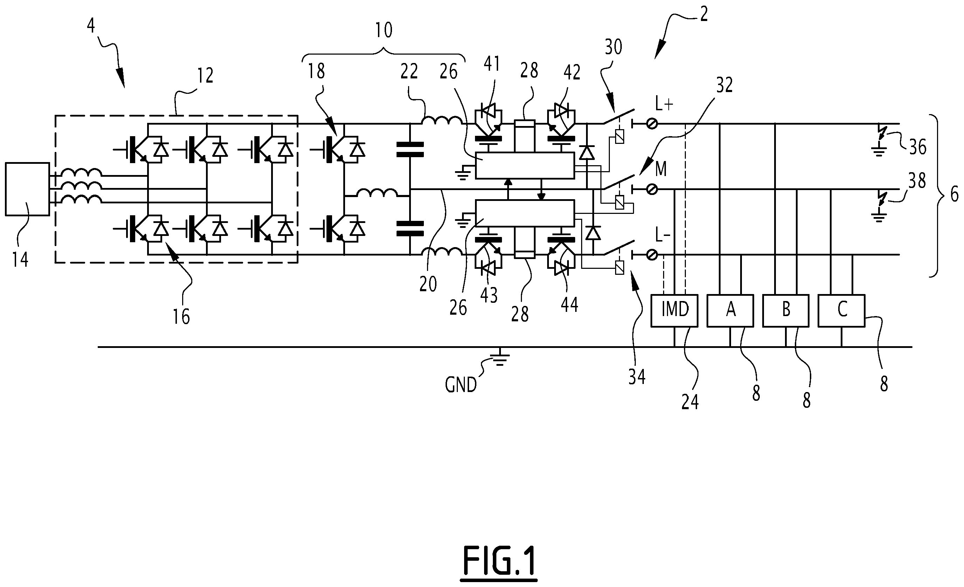

La figure 1 représente schématiquement une installation électrique 2, telle qu'une installation de distribution d'électricité.

L'installation 2 est alimentée par une source électrique 4.

L'installation 2 comporte une pluralité de lignes d'alimentation électriques 6, telles que des conducteurs électriques, qui permettent d'alimenter électriquement une ou plusieurs charges électriques 8. Par exemple, les charges électriques 8 sont connectées aux lignes d'alimentation électriques 6 au moyen de branchements ou de dérivations.

Dans de nombreux exemples, les charges électriques 8 sont des moteurs électriques, ou des machines industrielles, ou des systèmes de chauffage, ces exemples n'étant pas limitatifs. L'installation 2 peut aussi être utilisée pour fournir une alimentation électrique à des infrastructures ou à un site d'importance critique, tels qu'un hôpital ou une installation industrielle complexe.

De préférence, dans l'installation 2, les lignes d'alimentation électriques 6 ne sont pas connectées à la terre ou sont connectées avec une impédance maitrisée dans des conditions normales de fonctionnement. Une telle installation 2 est dite présenter un schéma de liaison à la terre de type IT dans la nomenclature française.

Dans l'exemple illustré sur la figure 1, les charges électriques 8 sont au nombre de trois. Cet exemple n'est pas limitatif et un nombre différent de charges électriques 8 pourrait être utilisé. Les charges électriques 8 sont ici identifiées individuellement par les références A, B et C.

Dans de nombreux modes de réalisation, l'installation 2 est une installation à courant continu (DC pour « Direct Current » en anglais).

La description qui va suivre est principalement faite en référence à une installation 2 à courant continu dans un souci de simplifier les explications, mais cela n'empêche pas qu'en variante, l'installation 2 pourrait être une installation à courant alternatif, et notamment une installation polyphasée, comme cela sera décrit dans ce qui suit.

De préférence, l'installation 2 présente une configuration bipolaire et comporte alors en sortie une première borne de sortie L+, une deuxième borne de sortie L- et une borne de sortie intermédiaire M, ou point milieu M, qui est par exemple connectée entre la première borne L+ et la deuxième borne L-. L'installation 2 comporte donc en sortie trois lignes d'alimentation 6 chacune connectée à une des bornes de sortie L+, L- et M.

Par exemple, la première borne de sortie L+ est portée à un premier potentiel électrique (par exemple, + 350 Volts). La deuxième borne de sortie L- est portée à un deuxième potentiel électrique, de préférence opposé au premier potentiel électrique (par exemple, - 350 Volts). Le point milieu M est porté à un potentiel électrique intermédiaire entre le premier potentiel électrique et le deuxième potentiel électrique (par exemple, à 0 Volts). En variante, les potentiels électriques pourraient être choisis différemment (par exemple, entre +700 Volts et -700 Volts). En une autre variante, les potentiels électriques pourraient être multipolaires (par exemple +350Volts, -350Volts, +700 Volts, -700 Volts).

Les charges électriques 8 sont connectées chacune à deux des lignes de sortie 6, en fonction de la tension électrique avec laquelle elles doivent être alimentées, mais aussi en fonction de leur degré d'importance, comme on le comprendra à la lecture de la description qui va suivre. De préférence, les charges les plus critiques comportent une connexion au point milieu M (ou plus exactement à la ligne d'alimentation 6 connectée au point milieu M).

Par degré d'importance, ou criticité, on désigne ici le fait que certaines charges électriques doivent être alimentées le plus longtemps possible, même en cas d'incident, par exemple parce qu'elles sont plus importantes que d'autres charges électriques 8 de l'installation 2.

Dans l'exemple illustré, la charge A est connectée entre la première borne de sortie L+ et la deuxième borne de sortie L-. La charge B est connectée entre la première borne de sortie L+ et le point milieu M. La charge C est connectée entre la deuxième borne de sortie L- et le point milieu M. Cet exemple n'est pas limitatif, d'autres configurations pouvant être utilisées en variante.

De préférence, les charges critiques 8 sont connectées par au moins une de leurs bornes à la ligne d'alimentation 6 intermédiaire, c'est-à-dire à la ligne d'alimentation 6 associée à la borne de sortie intermédiaire M. L'autre borne de chacune de ces charges 8 critiques est alors connectée à l'autre borne de sortie L+ ou L-. Les charges 8 non-critiques sont quant à elles connectées entre la première borne de sortie L+ et la deuxième borne de sortie L-. Dans l'exemple illustré, les charges B et C sont des charges critiques, tandis que la charge A est une charge non critique. On peut également assigner à l'une des première et deuxième bornes de sorties L+ ou L- une priorité plus élevée que l'autre borne.

Les charges électriques 8 sont de préférence également connectées à une masse électrique GND (ou terre) de l'installation 2.

L'installation 2 comporte également un dispositif de conversion de puissance 10 connecté entre l'alimentation 4 et les lignes de sortie 6 (« midpoint converter » en anglais).

Par exemple, le dispositif de conversion de puissance 10 est un convertisseur de puissance continu-continu.

Dans l'exemple illustré, la source 4 comporte un redresseur 12 raccordé à une source de tension alternative 14 amont, telle qu'un réseau de distribution électrique (secteur). En variante, la source de tension alternative 14 pourrait être un générateur ou un dispositif de stockage d'énergie, ou toute source appropriée.

Par exemple, le redresseur 12 est un redresseur à découpage et comporte une pluralité d'interrupteurs de puissance 16, tels que des transistors, pilotables par un contrôleur électronique, d'autres modes de réalisation étant néanmoins possibles en variante.

Le dispositif 10 comporte par exemple des interrupteurs de puissance 18, tels que des transistors, connectés entre des bornes de l'alimentation 4 et un point milieu 20 qui est raccordé à la borne intermédiaire de sortie M.

Le dispositif 10 peut également comporter des éléments 22 configurés pour conditionner les courants et/ou les tensions électriques délivrés par l'alimentation 4, tel qu'un filtre LC.

L'installation 2 comporte un dispositif de surveillance d'isolement 24, aussi nommé contrôleur permanent d'isolement 24 (IMD, ou « Insulation Monitoring Device » en anglais).

Le dispositif de surveillance 24 est configuré pour détecter un défaut d'isolement, notamment un défaut d'isolement résultant d'une mise en contact inopinée entre une des phases (ou le neutre) et la terre.

Par exemple, le dispositif de surveillance 24 comporte un dispositif de mesure pour mesurer une impédance de défaut reliant la ou les charges 8 surveillées et la terre GND, et plus exactement, une impédance électrique de défaut reliant les lignes d'alimentation 6 connectant cette charge électrique 8 et la terre.

Par exemple, le dispositif de surveillance 24 est connecté à la terre GND et à au moins une partie des lignes d'alimentation 6.

Par exemple, dans l'exemple illustré sur la figure 1, l'une des bornes du dispositif de surveillance 24 est connectée à la ligne d'alimentation 6 qui est raccordée au point milieu M. L'autre borne du dispositif de surveillance 24 est connectée à la ligne d'alimentation 6 qui est raccordée à la première borne de sortie L+ (ligne haute) ou à la ligne d'alimentation 6 qui est raccordée à la deuxième borne de sortie L- (ligne basse), comme illustré par les lignes en pointillés sur la figure 1.

De tels dispositifs de surveillance 24 sont connus et ne sont pas décrits plus en détail.

L'installation 2 comporte également un dispositif de supervision 26 configuré pour détecter et/ou localiser un défaut d'isolement, par exemple au moyen de dispositifs de mesure 28, tels que des capteurs de tension et/ou des capteurs de courant. Les dispositifs de mesure 28 sont configurés pour mesurer une grandeur électrique dans l'installation, tel qu'un courant ou une tension, notamment dans les lignes d'alimentation 6.

Le dispositif de supervision 26 est également configuré pour déconnecter une ou plusieurs des lignes d'alimentation 6 afin de faire disparaître un défaut électrique, par exemple au moyen d'interrupteurs 41, 42, 43, 44, 30, 32 et 34 associés aux lignes d'alimentation 6. Par exemple, des premiers interrupteurs 30, 32 et 34 sont associés aux bornes de sorties L+, L- et M. Avantageusement, des deuxièmes interrupteurs 41, 42, 43, 44, tels que des interrupteurs statiques, peuvent être associés aux sorties correspondantes du dispositif de conversion de puissance 10.

De préférence, le dispositif de supervision 26 fonctionne conjointement avec le dispositif de surveillance 24. En variante, le dispositif de supervision 26 peut fonctionner indépendamment du dispositif de surveillance 24.

Dans l'exemple illustré, les interrupteurs 41, 42 sont associés à la première borne de sortie L+. Les interrupteurs 43, 44 sont associés à la deuxième borne de sortie L-. Les interrupteurs 30, 32 et 34 sont respectivement associés à la première borne de sortie L+, à la borne de sortie intermédiaire M et à la deuxième borne de sortie L-.

Chacun des interrupteurs 41, 42, 43, 44, 30, 32 et 34 est piloté par le dispositif de supervision 26 et peut être commuté entre un état fermé, dans lequel la ligne d'alimentation 6 correspondante (et la charge 8 qui y est raccordée) est alimentée, et un état ouvert, dans lequel la ligne d'alimentation 6 correspondante (et la charge 8 qui y est raccordée) est déconnectée.

Les interrupteurs 30, 32 et 34 peuvent être des appareils de commutation électromécaniques, ou des interrupteurs de puissance à semi-conducteurs, tels que des transistors de puissance ou des thyristors ou tout élément analogue, ou une combinaison de ces éléments.

Les deuxièmes interrupteurs 41, 42, 43 et 44 peuvent être des appareils de commutation électromécaniques, ou des interrupteurs de puissance à semi-conducteurs, tels que des transistors de puissance ou des thyristors ou tout élément analogue, ou une combinaison de ces éléments.

Les deuxièmes interrupteurs 41, 42, 43 et 44 permettent de faciliter la coupure du courant. Lorsque les deuxièmes interrupteurs 41, 42, 43 et 44 sont utilisés conjointement avec les premiers interrupteurs 30, 32 et 34, alors les premiers interrupteurs 30, 32 et 34 peuvent être des sectionneurs.

En variante, les deuxièmes interrupteurs 41, 42, 43 et 44 peuvent être omis. La déconnexion d'une ou de plusieurs des bornes de sortie L+, L- et M et (des lignes d'alimentation 6 correspondantes) est assurée par les seuls premiers interrupteurs 30, 32 et 34. Dans ce cas, de préférence, les premiers interrupteurs 30, 32 et 34 sont des disjoncteurs-sectionneurs.

Par exemple, un premier dispositif de mesure 28 est associé avec la ligne d'alimentation « haute » correspondant à la première borne de sortie L+ et un deuxième dispositif de mesure 28 est associé avec la ligne d'alimentation « basse » correspondant à la deuxième borne de sortie L-, d'autres configurations étant néanmoins possibles en variante.

Par exemple, le dispositif de supervision 26 comporte un dispositif électronique de commande incluant un processeur, tel qu'un microcontrôleur programmable ou un microprocesseur. Le processeur est couplé à une mémoire informatique, ou à tout support d'enregistrement de données lisible par ordinateur, qui comporte des instructions exécutables et/ou un code logiciel. En variante, le dispositif de supervision 26 peut comporter un processeur de traitement du signal (DSP), ou un composant logique reprogrammable (FPGA), ou un circuit intégré spécialisé (ASIC), ou tout élément équivalent, ou par tout circuit électronique approprié.

Dans l'exemple illustré, le dispositif de supervision 26 comporte deux processeurs couplés entre eux et étant chacun connecté à un dispositif de mesure 28. Toutefois, dans de nombreuses variantes, cette disposition pourrait être remplacée par un seul processeur.

Par exemple, le dispositif de supervision 26, les dispositifs de mesure 28 et les interrupteurs 41, 42, 43, 44, 30, 32 et 34 forment un système de protection électrique pour gérer les défauts d'isolement dans l'installation 2 en assurant un bon fonctionnement des charges 8, notamment donnant la priorité aux charges 8 les plus critiques lorsqu'une partie de l'installation doit être déconnectée en cas de multiples défauts d'isolement.

De façon générale, le dispositif de supervision 26 est programmé pour, lorsque des défauts d'isolement se produisent dans l'installation 2, déconnecter au moins une partie des charges électriques 8 tout en permettant, dans la mesure du possible, à au moins une partie des charges électriques 8 de continuer à être alimentées électriquement.

Deux défauts d'isolement sont illustrés schématiquement sur l'exemple de la figure 1 : un premier défaut d'isolement 36 sur la ligne d'alimentation 6 associée à la première borne de sortie L+, et un deuxième défaut d'isolement 38 sur la ligne d'alimentation 6 associée à la borne de sortie intermédiaire M (ou point milieu M). Il est également possible qu'un défaut soit présent sur la ligne d'alimentation 6 associée à la deuxième borne de sortie L-, mais cette éventualité n'est pas illustrée dans un souci de simplification.

En pratique, lorsqu'un premier défaut d'isolement 36 ou 38 survient de façon isolée, ce premier défaut ne pose pas nécessairement un danger immédiat pour l'installation 2, par exemple parce qu'un transformateur de distribution situé en amont de la source 14 est suffisamment isolé de la terre.

Le dispositif de supervision 26 est donc programmé pour ne pas interrompre le fonctionnement de l'installation 2 lorsqu'un seul défaut d'isolement est détecté.

L'installation peut continuer à fonctionner en attendant que le défaut soit localisé et qu'un opérateur puisse être dépêché sur place pour supprimer le problème à l'origine du défaut.

En revanche, si un deuxième défaut d'isolement est détecté alors que le premier défaut d'isolement est toujours présent, alors le dispositif de supervision 26 est configuré pour actionner l'un ou plusieurs des interrupteurs 41, 42, 43, 44, 30, 32 ou 34 pour supprimer immédiatement au moins l'un des défauts d'isolement.

De préférence, le dispositif de supervision 26 est configuré pour, dans un tel cas, piloter des interrupteurs 41, 42, 43, 44, 30, 32 ou 34 suivant une ou plusieurs lois de commande afin de garantir que les charges 8 non critiques soient déconnectées en premier et que les charges 8 critiques soient déconnectées le plus tard possible, voire pas du tout déconnectées si la situation le permet.

La façon de détecter un défaut d'isolement est connue en tant que telle et n'est pas décrite plus en détail. De tels défauts peuvent être détectés, par exemple à partir de mesures électriques réalisées par les dispositifs de mesure 28.

Le dispositif de supervision 26 peut être programmé de la façon suivante.

Selon une première loi de commande, si un premier défaut d'isolement est détecté sur la ligne d'alimentation 6 raccordée à la borne de sortie intermédiaire M, alors, en cas de détection d'un deuxième défaut d'isolement sur une ligne d'alimentation 6 raccordée à une autre des bornes de sortie (la première borne L+ ou la deuxième borne L-), alors c'est l'interrupteur correspondant à cette dernière borne qui est ouvert pour déconnecter la ligne d'alimentation correspondante 6, pour faire disparaître le deuxième défaut d'isolement.

Ainsi, dans le cas où le deuxième défaut se produit sur la ligne d'alimentation 6 raccordée à la première borne L+, alors c'est un ou plusieurs des interrupteurs 41, 42, 30 correspondants qui sont ouverts, les autres interrupteurs 43, 44, 32 et 34 étant maintenus fermés.

De cette manière, la ou les charges 8 qui sont connectées entre le point milieu M et l'autre borne de sortie L- (qui elle n'est affectée par aucun défaut d'isolement) continuent à être alimenté électriquement par l'installation 2 et peuvent continuer à être alimentées sans danger, puisque les charges correspondantes 8 ne sont affectées que par le premier défaut d'isolement, mais pas par le deuxième défaut d'isolement.

Cela permet de prolonger le fonctionnement d'au moins une partie de l'installation 2 pour continuer à alimenter les charges 8 critiques, au moins temporairement, le temps que la cause du défaut d'isolement soit supprimée par un opérateur.

De façon analogue, dans le cas où le deuxième défaut se produit sur la ligne d'alimentation 6 raccordée à la deuxième borne de sortie L-, alors c'est un ou plusieurs des interrupteurs 43, 44, 34 correspondants qui sont ouverts, les autres interrupteurs 41, 42, 30 et 32 étant maintenus fermés.

Selon une deuxième loi de commande, si le premier défaut d'isolement est détecté sur une ligne d'alimentation 6 raccordée à la première borne de sortie L+ ou à la deuxième borne de sortie L-, alors, lorsqu'un deuxième défaut d'isolement est détecté dans l'installation 2, le dispositif de supervision 26 est programmé pour déconnecter la ligne d'alimentation sur laquelle le premier défaut a été détecté, au moyen de l'interrupteur 41, 42, 43, 44, 30 ou 34 correspondant, et ce quel que soit l'endroit où le deuxième défaut d'isolement est détecté.

Par exemple, dans le cas où le premier défaut se produit sur la ligne d'alimentation 6 raccordée à la première borne L+, alors c'est un ou plusieurs des interrupteurs 41, 42, 30 correspondants qui sont ouvert lorsque le deuxième défaut est détecté, les autres interrupteurs 43, 44, 32 et 34 étant maintenus fermés, peu importe où est détecté le deuxième défaut.

De cette manière, là encore, la ou les charges 8 qui sont connectées entre le point milieu M et l'autre borne de sortie L- (qui elle n'est affectée par aucun défaut d'isolement) continue à être alimenté électriquement par l'installation 2 et peut continuer à être alimenté sans danger, puisque les charges correspondantes 8 ne sont affectées que par le premier défaut d'isolement, mais pas par le deuxième défaut d'isolement.

Ainsi, dans ces lois de commande, le dispositif de supervision 26 est configuré pour déconnecter en priorité la première borne de sortie L+ ou la deuxième borne de sortie L-pour éliminer un des deux défauts d'isolement, tout en maintenant la borne de sortie intermédiaire M (le point milieu M) connecté le plus longtemps possible.

Cela permet d'assurer une continuité de service améliorée, pour les raisons expliquées ci-dessus.

Un autre avantage est que la déconnexion du point milieu en dernier, après le ou les autres bornes de sortie L+ et L-, permet d'éviter de créer des surtensions sur les charges électriques 8, ce qui pourrait se produire si le point milieu étant déconnecté en premier (ne laissant connectées que les bornes de sortie présentant la différence de potentiel la plus élevée).

En variante, on peut définir une troisième loi de commande dans le cas où l'on a assigné des priorités différentes à la première borne de sortie L+ et à la deuxième borne de sortie L-. Les charges présentant la criticité la plus élevée étant connectées entre le point milieu M et la borne de sortie L+ ou L- présentant la priorité la plus élevée.

Ainsi, dans le cas où le premier défaut et le deuxième défaut se produisent sur les bornes de sortie L+ et L- (c'est-à-dire que le premier défaut se produit sur l'une ou l'autre des bornes de sortie L+ et L- et que le deuxième défaut se produit sur l'autre des bornes de sortie L+ et L-), alors le dispositif de supervision 26 est programmé pour déconnecter la borne de sortie L+ ou L- qui présente la priorité la moins élevée, pour éliminer le défaut d'isolement associé à cette borne de sortie, de manière à pouvoir maintenir l'autre borne de sortie L+ ou L- connectée.

Cela permet d'assurer une continuité de service améliorée, pour les raisons expliquées ci-dessus.

En revanche, de préférence, une charge 8 même critique sera déconnectée s'il n'y pas d'autre possibilité de préserver la sécurité électrique de l'installation.

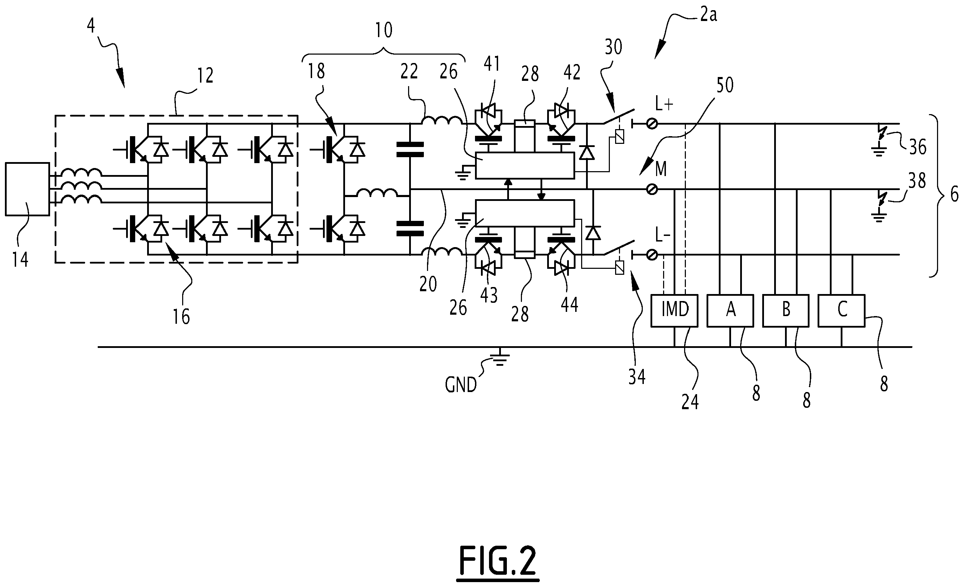

La figure 2 représente une première variante du mode de réalisation de la figure 1.

Sur la figure 2 est représentée une installation électrique 2a similaire à l'installation 2 de la figure 1, et qui en diffère notamment par le fait que l'interrupteur 32 associé à la borne de sortie intermédiaire M est remplacé par un conducteur électrique 50.

En d'autres termes, la borne de sortie intermédiaire M (le point médian M) ne peut pas être déconnectée par le dispositif de supervision 26. Cela simplifie la réalisation du dispositif de supervision 26 et garantit que le point médian M ne pourra pas être déconnecté avant la première borne de sortie L+ ou la deuxième borne de sortie L-.

Alternativement, cette configuration pourrait être obtenue sans avoir recours au conducteur électrique 50, mais plutôt en neutralisant l'interrupteur 32 associé à la borne de sortie intermédiaire M, par exemple en programmant le dispositif de supervision 36 pour que l'interrupteur 32 ne puisse pas être ouvert et qu'il reste fermé.

Ainsi, le dispositif de supervision est configuré pour empêcher la déconnexion de la borne de sortie intermédiaire M.

Cette variante est particulièrement utile pour satisfaire à certaines normes dans certains territoires.

Les éléments de l'installation électrique 2a selon cette première variante qui sont analogues au premier mode de réalisation portent les mêmes références que l'installation 2 et ne sont pas décrits en détail, dans la mesure où la description ci-dessus peut leur être transposée.

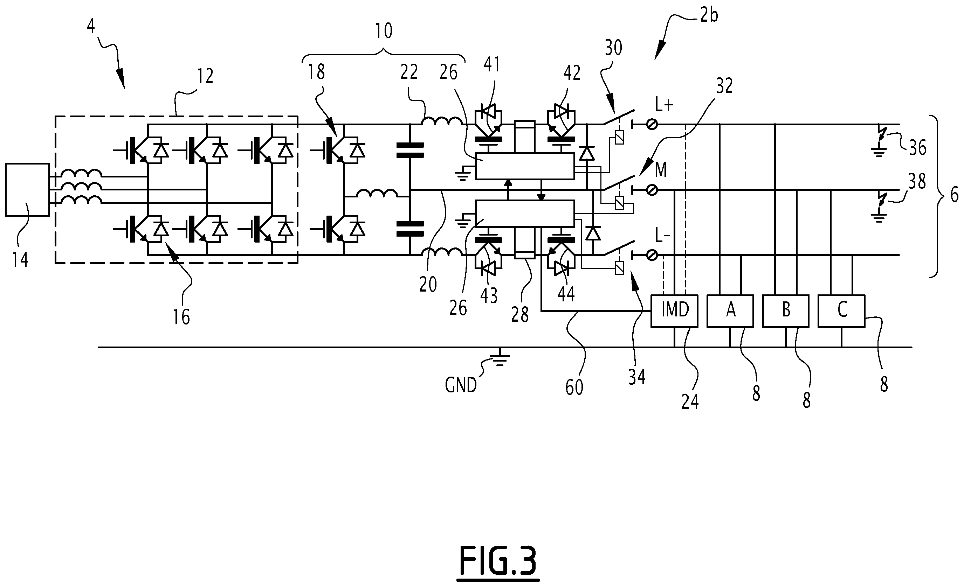

La figure 3 représente une deuxième variante du mode de réalisation de la figure 1.

Sur la figure 3 est représentée une installation électrique 2b similaire à l'installation 2 de la figure 1, et qui en diffère notamment par le fait que la détection et/ou la localisation des défauts d'isolement 36, 38 est réalisée par le dispositif de surveillance 24, ce dernier étant alors couplé au dispositif de supervision 26, par exemple par l'intermédiaire d'une liaison de données 60, telle qu'une liaison câblée.

Les éléments de l'installation électrique 2b selon cette deuxième variante qui sont analogues au premier mode de réalisation portent les mêmes références que l'installation 2 et ne sont pas décrits en détail, dans la mesure où la description ci-dessus peut leur être transposée.

De nombreux autres modes de réalisation sont possibles.

Dans des modes de réalisation alternatifs, l'installation pourrait être une installation à courant alternatif (AC pour Alternative Current en anglais) comprenant une ou plusieurs phases. Notamment, l'installation pourrait être une installation triphasée.

Dans ce cas, le redresseur 12 et la structure du dispositif de conversion 10 peuvent être omis. Dans ces modes de réalisation, il y a une borne de sortie par phase (par exemple, pour chaque phase, une borne « L » en remplacement des première ou deuxième bornes L+ et L-) et une borne de neutre qui correspond au point médian. Ainsi, dans un système triphasé, il y a trois bornes de sortie (une par phase) et un point médian associé au neutre.

Le fonctionnement du dispositif de supervision 26 est alors adapté en conséquence, par exemple pour mesurer des informations provenant de plusieurs dispositifs de mesure 28 supplémentaires et pour piloter des interrupteurs 41, 42, 43, 44, 30, 32, 34 supplémentaires associés à ces bornes de sortie supplémentaires. Mais, la façon de piloter les interrupteurs selon les lois de commande prédéfinies est analogue ou identique à celle décrite, la sortie L associée à chaque phase électrique étant traitées indépendamment par le dispositif de supervision 26.

En pratique, si un défaut apparaît sur une première phase et un deuxième défaut sur une deuxième phase, les lois de commande s'appliquent de la même façon que décrite ci-dessus. Le dispositif de supervision détecte les défauts dans chacune de ces deux phases et déconnecte les deux phases en question. Seule la troisième phase et le neutre vont rester alimentés.

De plus, dans le cas où les charges électriques 8 sont alimentées par plusieurs phases et que leur fonctionnement est susceptible d'être perturbé en cas de perte d'une partie de leur alimentation, il est avantageux d'équiper tout ou partie de ces charges électriques 8 d'un relais de protection contre la perte d'une phase sur leur entrée d'alimentation. Cela permet d'interrompre l'alimentation électrique de toute la charge 8 lorsque seule une phase est déconnectée. En effet, avec la configuration polyphasée décrite ci-dessus, le dispositif de supervision 26 peut être amené, lorsque des défauts d'isolement sont détectés à n'ouvrir qu'un des conducteurs de phase, ce qui laisse les charges 8 concernées encore partiellement connectées aux lignes d'alimentation 6.

Dans des modes de réalisation alternatifs, l'installation pourrait être de type multipolaire, c'est-à-dire alimentée électriquement par plusieurs sources 14.

Dans ce cas, chacune de source est préférentiellement équipée d'un dispositif de mesure 28 et des interrupteurs associés (41, 42, 43, 44, 30, 32, 34) pour chacun des conducteurs actif (L+, L-, M, ...). Le réseau est également équipé d'un ou de plusieurs dispositifs de détection de défaut (24). Les dispositifs de mesure 28 des différentes sources peuvent être interconnectés pour pouvoir échanger les informations sur les grandeurs électriques mesurés et coordonner leur action.

Si un premier défaut est détecté, l'installation continue à être alimentée. En cas de l'apparition d'un deuxième défaut, chacun des dispositifs de mesure évalue l'information des capteurs de courant et de tension pour localiser les 2 défauts. Si les dispositifs de mesure ne sont pas interconnectés, ils doivent être configurés de sorte à obtenir la même priorisation de la déconnexion des phases et les charges associées (si c'est la phase L+ qui est plus prioritaire que la phase L-, toutes les dispositifs de mesures sont configurés ainsi).

Si les dispositifs de mesure sont interconnectés, une coordination de leurs actions est effectuée de sorte que l'ouverture des mêmes sources du même conducteur d'alimentation est effectuée en cas de détection d'un deuxième défaut.

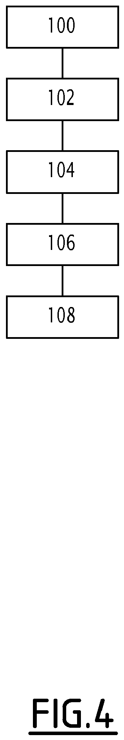

Un exemple de fonctionnement du dispositif de supervision 26 est maintenant décrit en référence au diagramme de la figure 4.

Le dispositif de supervision 26 est mis en marche lors d'une étape 100, par exemple au démarrage de l'installation 2. A ce stade, l'installation 2 est alimentée et ne comporte aucun défaut d'isolement.

Lors d'une étape 102, un premier défaut d'isolement est détecté par le dispositif de supervision 26, à partir d'une ou de plusieurs grandeurs électriques, telles que la tension électriques, mesurées par le ou les dispositifs de mesure 28. Par exemple, cette détection est réalisée suivant des méthodes de détection et d'analyse connues, à partir des grandeurs électriques mesurées par le ou les dispositifs de mesure 28. En variante, comme expliqué précédemment, cette détection pourrait au moins en partie, voire totalement, être réalisée par le dispositif de supervision 24.

Par exemple, le premier défaut d'isolement est détecté sur une ligne d'alimentation ou sur une charge électrique 8 associée à une ligne d'alimentation raccordée à l'une des bornes de sortie L+, L- ou M.

Lors d'une étape 104, un deuxième défaut d'isolement est détecté par le dispositif de supervision 26, à partir d'une ou de plusieurs grandeurs électriques, telles que la tension et/ou le courant électriques et/ou l'impédance, mesurées par le ou les dispositifs de mesure 28. Par exemple, cette détection est réalisée suivant des méthodes de détection et d'analyse connues, à partir des grandeurs électriques mesurées par le ou les dispositifs de mesure 28. Par exemple, le deuxième défaut d'isolement est détecté sur une ligne d'alimentation ou sur une charge électrique 8 associée à une ligne d'alimentation raccordée à l'une des bornes de sortie L+, L- ou M, mais à un emplacement différent du premier défaut d'isolement.

Lors d'une étape 106, le dispositif de supervision 26 commande automatiquement l'ouverture d'un des interrupteurs 41, 42, 43, 44, 30, 32, 34 associés aux bornes de sorties L+, L- ou M, afin de supprimer l'un des défauts électriques détectés.

Le choix de l'interrupteur devant être ouvert est décidé automatiquement en fonction de la localisation des défauts d'isolement détectés et de lois de commande prédéfinies.

Par exemple, comme expliqué ci-dessus, si un premier défaut d'isolement est détecté sur la borne de sortie intermédiaire M et que le deuxième défaut d'isolement est détecté sur la première borne L+ ou sur la deuxième borne L-, alors c'est l'interrupteur correspondant à cette autre borne qui est ouvert pour déconnecter la ligne d'alimentation correspondante 6, pour faire disparaître le deuxième défaut d'isolement, sans déconnecter la borne de sortie intermédiaire M.

Dans un autre exemple, si le premier défaut d'isolement est détecté sur la première borne de sortie L+ ou sur la deuxième borne de sortie L-, alors lors de l'étape 106, le dispositif de supervision 26 déconnecte, la ligne d'alimentation sur laquelle le premier défaut a été détecté, au moyen de l'interrupteur 41, 42, 43, 44, 30 ou 34 correspondant, et ce quel que soit l'endroit où le deuxième défaut d'isolement est détecté.

Et dans un autre exemple, dans le cas où le premier défaut et le deuxième défaut se produisent sur les bornes de sortie L+ et L-, sans affecter la borne de sortie intermédiaire M (le point médian M), alors le dispositif de supervision 26 est programmé pour déconnecter la borne de sortie L+ ou L- qui présente la priorité la moins élevée, pour éliminer le défaut d'isolement associé à cette borne de sortie, de manière à pouvoir maintenir l'autre borne de sortie L+ ou L- connectée, sans déconnecter la borne de sortie intermédiaire M.

Lors de l'étape 108, à la suite de l'ouverture d'un des interrupteurs, l'un des deux défauts d'isolement a disparu. L'installation 2 peut continuer à fonctionner, au moins temporairement, en l'absence de deuxième défaut électrique. Une partie des charges électriques 8 sont déconnectées, mais une autre partie des charges électriques 8 (de préférence, les charges jugées les plus critiques) continue à être alimentée.

En variante, les étapes pourraient être exécutées dans un ordre différent. Certaines étapes pourraient être omises. L'exemple décrit ne fait pas obstacle à ce que, dans d'autres modes de réalisation, d'autres étapes soient mises en œuvre conjointement et/ou séquentiellement avec les étapes décrites.

Toute caractéristique de l'un des modes de réalisation ou variante décrite ci-dessus, peut être mise en œuvre dans les autres modes de réalisation et variantes décrits.

## Revendications

1. Système pour gérer des défauts d'isolement dans une installation électrique (2 ; 2a ; 2b), l'installation électrique comportant une alimentation électrique (4), un dispositif de conversion de puissance (10), et des lignes d'alimentation électriques étant configurées pour alimenter électriquement des charges électriques (8), chaque ligne d'alimentation électrique étant raccordée à une borne de sortie du dispositif de conversion de puissance, choisie parmi une première borne de sortie (L+), une deuxième borne de sortie (L-) et une borne de sortie intermédiaire (M), le système comportant un dispositif de supervision (26), des dispositifs de mesure (28) configurés pour mesurer une grandeur électrique dans l'installation, et des interrupteurs (41, 42, 43, 44, 30, 32, 34) pilotés par le dispositif de supervision, le dispositif de supervision étant configuré pour :
• détecter un premier défaut d'isolement dans l'installation ;
• détecter un deuxième défaut d'isolement dans l'installation ;
• commander automatiquement l'ouverture d'un des interrupteurs (41, 42, 43, 44, 30, 32, 34) associés aux bornes de sorties (L+, L-, M) afin de supprimer l'un des défauts électriques détectés, le choix de l'interrupteur à ouvrir étant réalisé en fonction de la localisation des défauts d'isolement détectés et de lois de commande prédéfinies permettant de ne déconnecter qu'une partie des charges électriques.

2. Système selon la revendication précédente, dans lequel le dispositif de supervision est configuré pour, si le premier défaut d'isolement est détecté sur la borne de sortie intermédiaire (M) et si le deuxième défaut d'isolement est détecté sur la première borne de sortie (L+) ou sur la deuxième borne de sortie (L-), déconnecter l'interrupteur correspondant à cette autre borne de sortie pour faire disparaître le deuxième défaut d'isolement, sans ouvrir l'interrupteur (32) associé à la borne de sortie intermédiaire (M).

3. Système selon la revendication 1, dans lequel le dispositif de supervision étant configuré pour, si le premier défaut d'isolement est détecté sur la première borne de sortie (L+) ou sur la deuxième borne de sortie (L-), ouvrir l'interrupteur (41, 42, 43, 44, 30, 32, 34) correspondant à la borne de sortie pour laquelle le premier défaut a été détecté, au moyen de l'interrupteur, et ce quel que soit l'endroit où le deuxième défaut d'isolement est détecté.

4. Système selon l'une quelconque des revendications précédentes, dans lequel le dispositif de supervision est configuré pour, si le premier défaut et le deuxième défaut d'isolement se produisent sur la première borne de sortie (L+) et la deuxième borne de sortie (L-) et qu'aucun défaut d'isolement n'affecte la borne de sortie intermédiaire (M), déconnecter la borne de sortie qui parmi la première borne de sortie (L+) et la deuxième borne de sortie (L-) présente la priorité la moins élevée, pour éliminer le défaut d'isolement associé à cette borne de sortie de sortie, de manière à pouvoir maintenir l'autre borne de sortie (L+, L-) connectée, sans déconnecter la borne de sortie intermédiaire (M).

5. Système selon l'une quelconque des revendications précédentes, dans lequel le dispositif de supervision est configuré pour détecter automatiquement le premier défaut d'isolement et le deuxième défaut d'isolement dans l'installation (2 ; 2a) à partir des mesures fournies par les dispositifs de mesure (28).

6. Système selon l'une quelconque des revendications 1 à 4, dans lequel le dispositif de supervision est configuré pour détecter automatiquement le premier défaut d'isolement et le deuxième défaut d'isolement dans l'installation (2b) à partir des mesures fournies par un contrôleur permanent d'isolement (24) connecté à l'installation.

7. Système selon l'une quelconque des revendications précédentes, dans lequel le dispositif de supervision est configuré pour empêcher la déconnexion de la borne de sortie intermédiaire (M).

8. Installation de distribution électrique comportant une alimentation électrique (4), un dispositif de conversion de puissance (10), et des lignes d'alimentation électriques étant configurées pour alimenter électriquement des charges électriques (8), chaque ligne d'alimentation électrique étant raccordée à une borne de sortie du dispositif de conversion de puissance, choisie parmi une première borne de sortie (L+), une deuxième borne de sortie (L-) et une borne de sortie intermédiaire (M), le système comportant un dispositif de supervision (26) et étant conforme à l'une quelconque des revendications précédentes.

9. Installation selon la revendication 8, dans laquelle les charges présentant une priorité plus élevée sont connectées entre la borne de sortie intermédiaire (M) et l'une ou l'autre des première et deuxième bornes de sortie (L+, L-).

10. Procédé pour gérer des défauts d'isolement dans une installation électrique, l'installation électrique comportant une alimentation électrique (4), un dispositif de conversion de puissance (10), et des lignes d'alimentation électriques étant configurées pour alimenter électriquement des charges électriques (8), chaque ligne d'alimentation électrique étant raccordée à une borne de sortie du dispositif de conversion de puissance, choisie parmi une première borne de sortie (L+), une deuxième borne de sortie (L-) et une borne de sortie intermédiaire (M), le système comportant un dispositif de supervision (26), des dispositifs de mesure (28) configurés pour mesurer une grandeur électrique dans l'installation, et des interrupteurs (41, 42, 43, 44, 30, 32, 34) pilotés par le dispositif de supervision, le procédé comportant des étapes consistant à :
• détecter un premier défaut d'isolement dans l'installation ;
• détecter un deuxième défaut d'isolement dans l'installation ;
• commander automatiquement l'ouverture d'un des interrupteurs (41, 42, 43, 44, 30, 32, 34) associés aux bornes de sorties (L+, L-, M) afin de supprimer l'un des défauts électriques détectés, le choix de l'interrupteur à ouvrir étant réalisé en fonction de la localisation des défauts d'isolement détectés et de lois de commande prédéfinies permettant de ne déconnecter qu'une partie des charges électriques.
